Europäisches Patentamt

(19) European Patent Office

Office européen des brevets

(11) Veröffentlichungsnummer: **0 109 661**
**B1**

(12) **EUROPÄISCHE PATENTSCHRIFT**

(45) Veröffentlichungstag der Patentschrift:
26.08.87

(51) Int. Cl.⁴: **H 03 J 3/32, H 03 J 7/08**

(21) Anmeldenummer: 83111496.2

(22) Anmeldetag: 17.11.83

(54) **Abstimmeinheit für Geräte der Nachrichtentechnik.**

(30) Priorität: 20.11.82 DE 3242965

(43) Veröffentlichungstag der Anmeldung:
30.05.84 Patentblatt 84/22

(45) Bekanntmachung des Hinweises auf die Patenterteilung:
26.08.87 Patentblatt 87/35

(84) Benannte Vertragsstaaten:
AT BE CH DE FR GB IT LI LU NL SE

(56) Entgegenhaltungen:
DE - B - 2 744 213
US - A - 4 334 323

PATENTS ABSTRACTS OF JAPAN, Band 4, Nr. 28
(E-1)(510), 8 März 1980, Seite 10 E 1
PATENTS ABSTRACTS OF JAPAN, Band 6, Nr. 103
(E-112)(981), 12 Juni 1982

(73) Patentinhaber: **Deutsche Thomson-Brandt GmbH,**
**Hermann-Schwer-Strasse 3 Postfach 2060,**
**D-7730 Villingen-Schwenningen (DE)**

(72) Erfinder: **Maier, Gerhard, Reutestrasse 19,**
**D-7735 Dauchingen (DE)**

# Beschreibung

## Stand der Technik

Die Erfindung geht aus von einer Abstimmeinheit für Geräte der Nachrichtentechnik, insbesondere Fernseh- und Rundfunkempfangsgeräte unter Verwendung eines PLL-Systems, welches beim Abstimmen des Empfangsgerätes nacheinander die einzelnen Abstimmkreise auf optimale Werte abgleicht und die ermittelten Abstimmwerte den einzelnen Filterkreisen zuordnet.

Eine derartige Abstimmeinheit ist z.B. in der DE-OS 2 854 852 beschrieben, die mittels dreier Hilfsoszillatoren und diesen zugeordneten Analogspeichern unter Verwendung der PLL-Schaltung die Hochfrequenzkreise auf die gewünschte Empfangsfrequenz abstimmen. Bei dieser Abstimmeinheit wird auch dabei der Tuneroszillator beim Abgleich herangezogen. Ausserdem sind der Zahl der abzugleichenden Hochfrequenzkreise entsprechende Hilfsoszillatoren notwendig. Die Zahl der benötigten Hilfsoszillatoren und somit der Materialaufwand erhöht sich dann in besonderem Masse, wenn z.B. beim Abgleich eines Fernsehempfängers Band I, Band III und die Bänder IV und V abgeglichen werden sollen. Es besteht dabei die Gefahr von Mehrdeutigkeiten zwischen den Frequenzen des Tuneroszillators, der Hilfsoszillatoren und den Empfangsfrequenzen. Nachteilig für eine praktikable Realisierung der vorgeschlagenen Abstimmeinheit ist, dass die Erregerwicklung der Hilfsoszillatoren mit den einzelnen Spulen in den Hochfrequenzkreisen unerwünschte Resonanzen und Bedämpfungen der Kreise hervorrufen können, die auch noch eine unkontrollierbare Verstimmung der Kreise verursachen, wenn die Hilfsoszillatoren nach erfolgtem Abgleich abgeschaltet sind. Ausserdem sind Analogspeicher vorgesehen, die in zeitlichen Abständen nachgeladen werden müssen, um die optimalen Abstimmwerte zu erhalten. Aus diesen Gründen ist prinzipbedingt ein optimaler Abgleich des Empfangsgerätes nicht erreichbar. Ausserdem werden durch das sich laufend wiederholende Nachstimmen Störungen auf dem Bildschirm oder im Lautsprecher sichtbar bzw. hörbar.

In der Zeitschrift «Nachrichten elektronik», Heft 11/79, Seiten 365–368 wird ein Abstimmverfahren für Rundfunkempfänger beschrieben, das ebenfalls zusätzliche Hilfskreise in den Hochfrequenzfiltern anwendet. Auch hier ergeben sich nachteilige Beeinflussungen der Kreise im Betrieb des abgeglichenen Empfängers. Wie auf Seite 367 linke und mittlere Spalte angegeben, wird die Genauigkeit der Abstimmungen durch Spezialbauteile nur in Form von exakt gepaarten Dioden erzielt. Auch dies erfordert einen nicht ausser Acht zu lassenden Aufwand.

Es ist auch ein sich selbstabgleichender Tuner bekannt (US-A 4 333 323), bei welchem das Antennensignal während des Abgleichs vom Tunereingang abgetrennt werden muss. Es werden dabei zwei Generatoren als Hilfsoszillatoren eingeschaltet, wobei ein Oszillator aus dem PLL-kontrollierten Tuneroszillator besteht und der andere Oszillator freischwingend ist. Dadurch ergeben sich Ungenauigkeiten im Abgleich wegen des erheblichen Anteils von unerwünschten Mischprodukten. Abgesehen vom erheblichen Schaltungsaufwand ergeben sich nicht zu vernachlässigende Fehler im Abgleich.

## Aufgabe

Der Erfindung liegt die Aufgabe zugrunde, einen automatischen Selbstabgleich von Nachrichtenempfangsgeräten zu erreichen, ohne Verwendung von ausgesuchten Bauteilen und mit dem Ziel einer maximalen Amplitude und einer optimalen Selektion bei allen Empfangsbereichen, ohne in die HF-Empfangseinheit einzugreifen. Diese Aufgabe wird durch die in den Patentansprüchen angegebenen Massnahmen gelöst.

## Beschreibung

Nachstehend soll an einem Ausführungsbeispiel das Wesentliche der Erfindung mit Hilfe der Zeichnung erläutert werden.

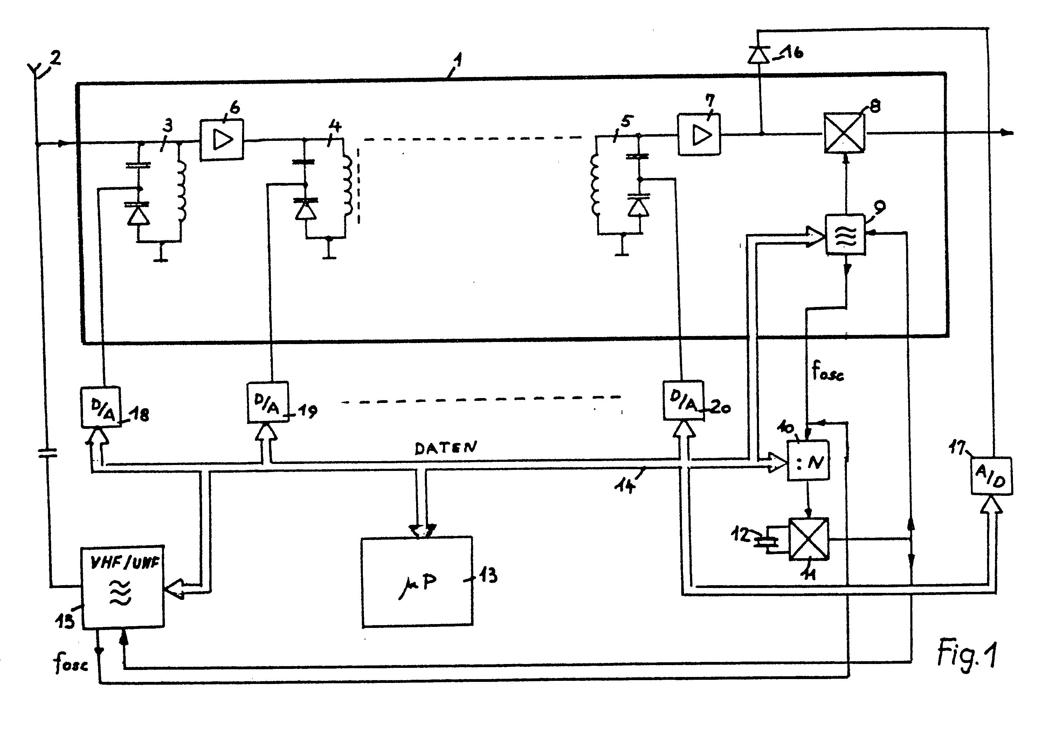

Fig. 1 zeigt ein Blockschaltbild der angemeldeten Abstimmeinheit

Fig. 2 zeigt Frequenzdurchlasskurven eines Empfängers zur Erläuterung der Wirkungsweise der Anordnung nach Fig. 1

Fig. 3 zeigt die Abstimmspannungsgrenzen für die verschiedenen Kreise.

Mit 1 ist ein Hochfrequenzteil eines Nachrichtenempfangsgerätes z.B. eines Fernsehempfängers, dargestellt. Diesem Empfangsteil wird über eine Antenne 2 das Empfangssignal zugeführt und mit Hilfe der Hochfrequenzkreise 3, 4, 5 selektiert und durch Verstärker 6, 7 verstärkt. In einer Mischstufe 8 wird das Zwischenfrequenzsignal erzeugt, das durch Überlagerung mit einer aus dem Oszillator 9 gewonnenen Frequenz entsteht. Der Oszillator 9 wird in seiner Frequenz mit Hilfe einer PLL-Schaltung eingestellt, die aus dem an den Oszillator 9 angeschlossenen Frequenzteiler 10 und dem Phasenkomparator 11 besteht, dem eine durch einen Quarz 12 erzeugte stabile Referenzfrequenz zugeführt wird. Die unterschiedlichen Oszillatorfrequenzen entstehen durch Veränderung des Teilungsfaktors des programmierbaren und von einem Mikroprozessor 13 über die Datenleitung 14 gesteuerten Frequenzteiler 10.

Der automatische Abgleich des Empfangsgerätes geht folgendermassen vor sich.

Bei jeder erneuten Kanalanwahl, die ebenfalls über den Mikroprozessor 13 gesteuert wird, wird der Empfängeroszillator 9 abgeschaltet und dafür ein einziger, ausschliesslich den gesamten Empfangsfrequenzbereich überdeckender Zusatzoszillator 15 auf mindestens zwei die gewünschte HF-Durchlasskurve charakterisierende umschaltbare Frequenzen eingestellt und mit Hilfe der vorhandenen PLL-Schaltung 10, 11, 12 stabil schwingend an den Antenneneingang der Empfangsschaltung gelegt. Nun wird mit dem Kreis 3 be-

ginnend und beim letzten Kreis 5 endend nacheinander auf eine optimale Ausgangsspannung hinter der letzten Stufe abgeglichen. Zwecks eines symmetrischen Abgleichs wird dabei der Zusatzoszillator 15, über die Datenleitung vom Mikroprozessor 13 gesteuert, jeweils auf mindestens zwei Frequenzen, die aber vom gewählten Empfangskanal abhängig sind, wechselnd umgeschaltet. Über eine Detektorschaltung 16 wird das Ergebnis dem Mikroprozessor 13 übermittelt, nachdem es mit Hilfe eines Analog-Digital-Wandlers 17 entsprechend umgeformt wurde. Die Abstimmspannungen werden individuell kontinuierlich verändert und vom Mikroprozessor 13 über Digital-Analogwandler 18, 19, 20 den einzelnen Kreisen zugeleitet, bis das festgelegte Ausgangskriterium am Analog-Digitalwandler 17 vorhanden ist. Bei den Digital-Analogwandlern handelt es sich um statische, monotone Wandler, d.h. sie werden nach der Dateneingabe vom Mikroprozessor 13 abgetrennt, um Gerätestörungen zu vermeiden und behalten das digitale Wort entweder bis zur Abstimmung auf einen anderen Kanal oder bis zu einer Feinverstimmung. Diese automatische Abstimmung erfolgt bei jeder erneuten Kanaleinstellung. Ein Abgleich der Kreise während der Fertigung des Empfangsgerätes kann somit entfallen. Bei einer vereinfachten Anordnung kann der zusätzliche Oszillator auf nur eine einzige Frequenz des angewählten Empfangskanals einstellbar sein, so dass der optimale Abgleich nur auf diese Frequenz erfolgt. Es müssen bei zwei- oder mehrkreisigen Bandfiltern die Kapazitätsdioden des gerade nicht am Abgleich beteiligten Kreises durch eine Spannung in Durchlassrichtung geschaltet werden.

Bei Empfang eines Offsetkanals oder für den Fall eines Suchlaufs wird das Datenwort für die einzelnen Digital-Analog-Wandler schrittweise verändert.

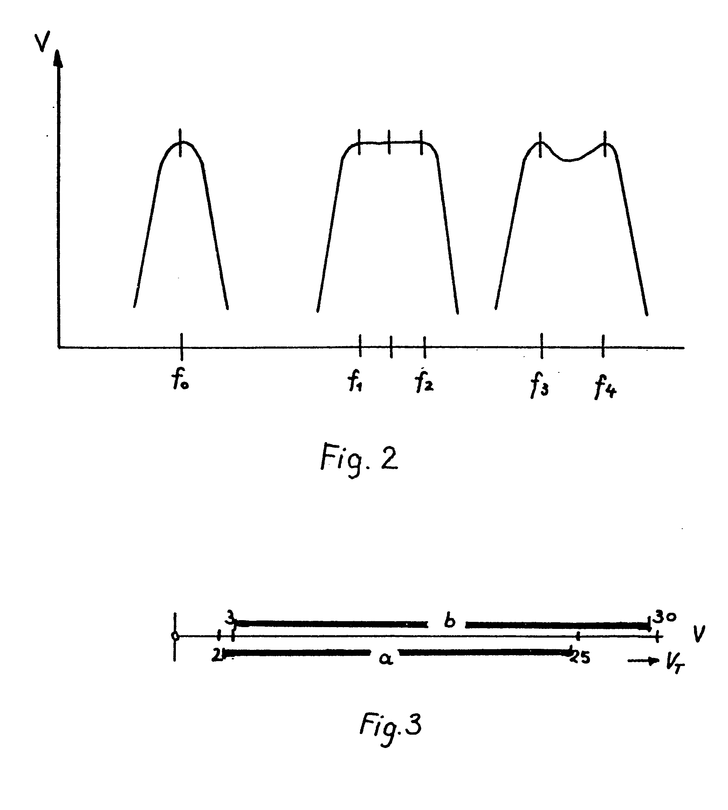

In Fig. 2 sind frequenzabhängige UHF-Durchlasskurven aufgetragen, die je nach Empfangsfrequenz innerhalb eines Bandes verschiedene Charakteristiken aufweisen. So ist bei tiefen Frequenzen innerhalb eines Bandes das L/C-Verhältnis und die Diodengüte schlecht. Hier wird der Zusatzoszillator 15 auf nur eine Frequenz f0 eingestellt. Bei mittleren Frequenzen innerhalb des Bandes wird der Zusatzoszillator wechselweise auf zwei Frequenzen $f_1$ und $f_2$ umgeschaltet, die im Abstand von 1 bis 2 MHZ symmetrisch zu einer Mittenfrequenz liegen.

Bei hohen Frequenzen eines Bandes ist das L/C-Verhältnis sowie die Diodengüte gut, und der Zusatzoszillator wird wechselweise auf zwei Frequenzen $f_3$ und $f_4$ umgeschaltet, die den Höckerfrequenzen der Durchlasskurve entsprechen. In Fig. 3 sind die Grenzen der Abstimmspannungsbereiche aufgetragen. Es hat sich zur Erzielung einer maximal möglichen HF-Selektion als zweckmässig erwiesen, dass die oberen und unteren Grenzen der Abstimmspannung für den Oszillatorkreis tiefer liegen als diejenigen für die HF-Filterkreise, z.B. für den VHF-Bereich liegt die Abstimmspannung für den Oszillatorkreis zwischen 2 und 25 V (a) und für die Filterkreise zwischen 3 und 30 V (b) wie in Fig. 3 dargestellt ist.

**Patentansprüche**

1. Elektronische Abstimmeinheit für Geräte der Nachrichtentechnik, insbesondere Fernseh- und Rundfunkempfangsgeräte unter Verwendung eines PLL-Systems, welches beim Abstimmen des Empfangsgerätes nacheinander die einzelnen Abstimmkreise auf optimale Werte abgleicht und die ermittelten Abstimmwerte den einzelnen Filterkreisen zuordnet, dadurch gekennzeichnet, dass jedesmal bei der Anwahl eines gewünschten Empfangskanales der Tuneroszillator (9) abgeschaltet und dafür ein einziger ausschliesslich das gesamte Empfangsfrequenzband überstreichender, die Empfangssignale simulierender Oszillator (15) an den Antenneneingang der Abstimmeinheit (1) (Tuner) anschaltbar ist, wobei der zusätzliche Oszillator (15) bei hohen Frequenzen wechselweise auf mindestens zwei im gewünschten Empfangskanal liegende Frequenzen und bei tiefen Frequenzen auf eine Frequenz umschaltbar ist, und eine das jeweilige HF-Signal demodulierende Einrichtung (16) vorgesehen ist, deren Ausgangsspannung über einen Analog-Digitalwandler (17) – einem μ Prozessor (13) zugeführt wird, der bei Feststellung einer maximalen und symmetrischen Ausgangskurve in der HF über DA-Wandler (18, 19, 20) den Wert der Abstimmspannung für die in den einzelnen Abstimmkreisen (3, 4, 5) befindlichen Kapazitätsdioden liefert.

2. Abstimmeinheit nach Anspruch 1, dadurch gekennzeichnet, dass bei zwei- und mehrkreisigen Bandfiltern die Kapazitätsdiode des gerade nicht am Abgleichvorgang beteiligten Kreises durch eine Schaltspannung in Durchlassrichtung vorgespannt ist.

3. Abstimmeinheit nach Anspruch 1, dadurch gekennzeichnet, dass der Abgleich der HF-Kreise (3, 4, 5) mit Hilfe des zusätzlichen Oszillators (15) bei nur einer einzigen Frequenz pro Empfangskanal vorgenommen wird.

4. Abstimmeinheit nach Anspruch 1, dadurch gekennzeichnet, dass die PLL-Schaltung (10–12) sowie die DA-Wandler (18–20) nach dem Abgleichvorgang vom Mikroprozessor (13) abgeschaltet sind.

5. Abstimmeinheit nach Anspruch 1, dadurch gekennzeichnet, dass zum Zwecke des Empfangs eines Offsetkanals oder bei Suchlauf das ermittelte Datenwort für die einzelnen DA-Wandler und für den Tuneroszillator inkremental veränderbar sind.

6. Abstimmeinheit nach Anspruch 1, dadurch gekennzeichnet, dass der zusätzliche Oszillator (15) von der im Tunerbaustein bereits vorhandenen PLL-Schaltung (10–12) kontrolliert wird.

7. Abstimmeinheit nach Anspruch 1, dadurch gekennzeichnet, dass der Abstimmspannungsbereich für den Oszillator tiefer liegt als für die HF-Filter zum Erzielen der maximal möglichen HF-Selektion.

## Claims

An electronic tuner for communications apparatus, in particular television and radio receiving apparatus using a PLL-system, in which during tuning of the receiving apparatus the individual tuning circuits one after another adjust to optimum values and the tuning values determined are assigned to the individual filter circuits, wherein each time upon selection of a desired receiving channel the tuner oscillator (9) is switched off and in its place a single oscillator (15) covering exclusively the whole receiving frequency band, which simulates the received signals, is switchable across the aerial input of the tuner (1), wherein the additional oscillator (15) at high frequencies is switchable alternately to at least two frequencies lying in the desired receiving channel, and at low frequencies to one frequency, and wherein a device (16) which demodulates the then HF-signal is provided, its output voltage being passed via an analogue-digital converter (17) to a microprocessor (13) which upon location of a maximum and symmetrical output curve in the HF via the DA converter (18, 19, 20) outputs the value of the tuning voltage for the capacitance diodes in the individual tuning circuits (3, 4, 5).

2. A tuner according to Claim 1, wherein in dual and multi-circuit band filters the capacitance diodes of the circuit not involved in the adjustment process is biassed in the forward direction by an unblocking voltage.

3. A tuner according to Claim 1, wherein the adjustment of the HF-circuits (3, 4, 5) is undertaken with the aid of the additional oscillator (15) for only one single frequency per receiving channel.

4. A tuner according to Claim 1, wherein the PLL-circuit (10–12) and the DA-converter (18–20) are switched off by the microprocessor after the adjustment process.

5. A tuner according to Claim 1, wherein for the purpose of receiving an offset channel or when searching the data word determined for the individual DA-converter and for the tuner oscillator can be altered incrementally.

6. A tuner according to Claim 1, wherein the additional oscillator (15) is controlled by the PLL-circuit (10–12) already present in the tuner.

7. A tuner according to Claim 1, wherein the tuning voltage range for the oscillator is lower than for the HF filter for achieving the maximum possible HF selectivity.

## Revendications

1. Unité électronique d'accord pour des appareils du domaine technique des communications, notamment des appareils récepteurs de télévision et de radio avec utilisation d'un système-PLL, qui, lors d'un accord de l'appareil récepteur, assure successivement le réglage des différents circuits d'accord à des valeurs optimales et affecte les valeurs d'accord obtenues aux différents circuits de filtrage, caractérisée en ce qu'à chaque fois lors de la sélection d'un canal de réception désiré, l'oscillateur de tuner (9) est désactivé et, à cet effet, un seul oscillateur (15), couvrant exclusivement toute la bande de fréquences de réception et simulant les signaux de réception, peut être relié à l'entrée d'antenne de l'unité d'accord (1) (tuner), auquel cas l'oscillateur additionnel (15) est commutable alternativement, pour de hautes fréquences, sur au moins deux fréquences placées dans le canal de réception désiré, et pour de basses fréquences sur une seule fréquence, et il est prévu un dispositif (16) assurant la démodulation du signal-HF correspondant et dont la tension de sortie est appliquée, par l'intermédiaire d'un convertisseur analogique-digital (17), à un microprocesseur (13) qui, lors de l'établissement d'une courbe de sortie maximale et symétrique dans la gamme HF, fournit par l'intermédiaire de convertisseurs D/A (18, 19, 20) la valeur de la tension d'accord pour les diodes capacitives se trouvant dans les différents circuits d'accord (3, 4, 5).

2. Unité d'accord selon la revendication 1, caractérisée en ce que, dans le cas de filtres de bandes à deux et plusieurs circuits, la diode capacitive du circuit n'intervenant précisément pas dans le processus de régulation, est rendue conductrice par une tension de commutation.

3. Unité d'accord selon la revendication 1, caractérisée en ce que l'accord des circuits-HF (3, 4, 5) est effectué au moyen de l'oscillateur additionnel (15) pour seulement une fréquence unique par canal de réception.

4. Unité d'accord selon la revendication 1, caractérisée en ce que le circuit-PLL (10–12) ainsi que les convertisseurs D/A sont désexcités par le microprocesseur (13) après le processus de régulation.

5. Unité d'accord selon la revendication 1, caractérisée en ce que, en vue de la réception d'un canal décalé ou bien dans une opération de recherche, le mot de données obtenu pour les différents convertisseurs D/A et pour l'oscillateur de tuner est modifiable de façon incrémentale.

6. Unité d'accord selon la revendication 1, caractérisée en ce que l'oscillateur additionnel (15) est contrôlé par le circuit-PLL (10–12) existant déjà dans le bloc de tuner.

7. Unité d'accord selon la revendication 1, caractérisée en ce que la gamme de tensions d'accord pour l'oscillateur est inférieure à celle correspondant au filtre-HF en vue d'obtenir le degré maximal possible de sélection-HF.

Fig. 1

0 109 661

Fig. 2

Fig. 3